# DEMANDE DE BREVET EUROPEEN

(11) **EP 4 671 876 A1**
(43) Date de publication de la demande: **31.12.2025**
(21) Numéro de dépôt: 24185120.3
(22) Date de dépôt: 27.06.2024
(51) Int. Cl.: G04B 15/14, G04B 17/06, G04D 3/00, B81C 1/00, G04B 18/08

(54) **PROCÉDÉ DE MODIFICATION DES DIMENSIONS D'UN CORPS COMPRENANT DU SILICIUM, NOTAMMENT POUR L'HORLOGERIE**

(71) Demandeur: Nivarox-FAR S.A., 2400 Le Locle (CH)
(72) Inventeur: STRANCZL, Marc, 1260 Nyon (CH); CUSIN, Pierre, 1423 Villars-Burquin (CH)
(74) Mandataire: ICB SA

(57) **Abrégé**

L'invention concerne un procédé de modification des dimensions d'un corps (1, 5), notamment pour l'horlogerie, le procédé comportant une première étape de formation du corps (1, 5) dans un matériau initial (2) comprenant du silicium, de préférence en totalité, le corps (1, 5) comportant des évidements (3, 6) s'étendant depuis la surface vers l'intérieur du corps (1, 5), caractérisé en ce qu'il comprend une deuxième étape de croissance d'oxyde de silicium de type SiO₂ à l'intérieur desdits évidements (3, 6), de manière à remplir les évidements et à déformer le corps (1, 5) afin de modifier ses dimensions.

## Description

### Domaine technique de l'invention

La présente invention se rapporte au domaine de la fabrication de composants comprenant du silicium, notamment pour l'horlogerie.

### Arrière-plan technologique

Dans certains domaines techniques, telle l'horlogerie, il est connu de fabriquer des composants comprenant du silicium, par exemple des ressorts-spiraux ou des guidages flexibles.

A cette fin, ces composants sont formés dans des plaquettes de type « wafer » en silicium, au moyen de techniques de gravure telles que la gravure au laser, la gravure au plasma, la gravure ionique réactive profonde dite DRIE ou encore la gravure humide.

Ces procédés de fabrication permettent d'obtenir des composants ayant des dimensions et des caractéristiques physiques précises. Cependant, il peut être nécessaire de modifier les dimensions ou la géométrie d'une partie du composant, sans pour autant nuire au reste du composant. Ces opérations sont particulièrement délicates, lorsqu'on a besoin d'augmenter les dimensions d'un composant, par exemple en l'allongeant, ou en le courbant.

Or, les procédés actuels ne permettent pas d'augmenter les dimensions de composants en silicium, après leur réalisation.

### Résumé de l'invention

Un but de la présente invention est de proposer un procédé de modification des dimensions d'au moins une partie d'un corps comprenant du silicium, qui permet de répondre aux besoins précités.

A cette fin, l'invention se rapporte à un procédé de modification des dimensions d'un corps, notamment pour l'horlogerie, le composant comportant au moins un corps, le procédé comportant une première étape de formation du corps dans un matériau initial comprenant du silicium, de préférence en totalité, le corps comportant des évidements s'étendant depuis la surface vers l'intérieur du corps, comprend une deuxième étape de croissance d'oxyde de silicium de type SiO₂ à l'intérieur desdits évidements, de manière à remplir les évidements et à déformer le corps afin de modifier ses dimensions.

Le procédé est remarquable en ce qu'il comprend une deuxième étape de croissance d'oxyde de silicium de type SiO₂ à l'intérieur desdits évidements, de manière à remplir les évidements et à déformer le corps afin de modifier ses dimensions.

Grâce au procédé, on peut modifier la géométrie d'un corps, notamment après sa fabrication, en particulier en l'allongeant ou en le courbant par exemple.

En effet, non seulement la croissance d'oxyde de silicium rempli les évidements, mais elle transforme aussi le silicium sur lequel il croît. Celui-ci est transformé en oxyde de silicium, qui a la particularité d'avoir un volume plus important que celui du silicium. Ainsi, le corps se déforme autour des évidements en augmentant de volume.

En outre, un tel procédé facilite la conception de certains composants, notamment lorsqu'ils sont monoblocs, et évite d'avoir à assembler des parties pour former le composant.

Selon un mode de réalisation particulier de l'invention, l'étape de croissance d'oxyde de silicium est produite par oxydation thermique, de préférence réalisée entre 800 et 1200 °C sous atmosphère oxydante à l'aide de vapeur d'eau ou de gaz de dioxygène.

Selon un mode de réalisation particulier de l'invention, les évidements ont des formes de tranchées.

Selon un mode de réalisation particulier de l'invention, les évidements ont une largeur sensiblement constante.

Selon un mode de réalisation particulier de l'invention, les évidements ont une largeur variable en fonction de la profondeur de la tranchée.

Selon un mode de réalisation particulier de l'invention, les évidements sont agencés sur un côté du corps, lors de la première étape, pour obtenir un corps courbe après la deuxième étape.

Selon un mode de réalisation particulier de l'invention, les évidements sont répartis uniformément dans le corps, de manière à former un corps dont le matériau initial a une épaisseur sensiblement constante dans le corps, lors de la première étape, pour obtenir un corps allongé axialement après la deuxième étape.

Selon un mode de réalisation particulier de l'invention, lors de la première étape, les évidements sont creusés après la formation du corps, par exemple grâce à un dispositif laser.

Selon un mode de réalisation particulier de l'invention, lors de la première étape, les évidements sont creusés pendant la formation du corps.

Selon un mode de réalisation particulier de l'invention, la première étape est effectuée via un processus de gravure ionique réactive profonde de type DRIE.

Selon un mode de réalisation particulier de l'invention, la première étape comprend un processus d'oxydation-désoxydation pour agrandir les évidements.

### Brève description des figures

D'autres caractéristiques et avantages de l'invention apparaîtront plus clairement à la lecture de la description suivante d'un mode de réalisation particulier de l'invention, donné à titre de simple exemple illustratif et non limitatif, et des figures annexées, parmi lesquelles :
les figures 1a) et 1b) sont des représentations schématiques montrant un premier type de composant réalisé avec le procédé de fabrication selon l'invention, après la première étape (figure 1a) et après la deuxième étape (figure 1b) ; et
les figures 2a) et 2b) sont des représentations schématiques montrant un deuxième type de composant réalisé avec le procédé de fabrication selon l'invention, après la première étape (figure 2a) et après la deuxième étape (figure 2b).

### Description détaillée de l'invention

L'invention se rapporte à un procédé de modification des dimensions d'un corps, notamment d'horlogerie. Le procédé comprend deux étapes principales.

Dans une première étape de formation, un corps 1, 5 est formé dans un matériau initial 2 comprenant du silicium, de préférence en totalité.

Le matériau initial peut être du silicium monocristallin quelle que soit son orientation cristalline, du silicium monocristallin dopé quelle que soit son orientation cristalline, du silicium amorphe, du silicium poreux, du silicium polycristallin, du nitrure de silicium, du carbure de silicium, du quartz quelle que soit son orientation cristalline.

Le corps 1, 5 est par exemple formé dans une plaquette de type wafer SOI comprenant une première couche de silicium.

Tout d'abord, on fait croître à la surface de la première couche de silicium une couche d'oxyde de silicium en exposant le ou les wafers à une atmosphère oxydante à haute température. La couche d'oxyde de silicium varie selon l'épaisseur de la couche de silicium à structurer. Elle se situe typiquement entre 1 et 4µm.

Puis, on va définir, par exemple dans une résine positive, les motifs que l'on souhaite réaliser par la suite dans le wafer en silicium à l'aide d'un masque.

Ce processus comprend les opérations suivantes :
- la résine est déposée, par exemple à la tournette, en une couche très mince d'épaisseur comprise entre 1 et 2µm ;
- une fois séchée, cette résine, aux propriétés photolithographiques, est exposée à travers un masque photolithographique (plaque transparente recouverte d'une couche de chrome, elle-même représentant les motifs souhaités) à l'aide d'une source lumineuse ;
- dans le cas précis d'une résine positive, les zones exposées de la résine sont ensuite éliminées au moyen d'un solvant, révélant alors la première couche d'oxyde. En l'occurrence, les zones toujours recouvertes de résine définissent les zones que l'on ne souhaite pas voir attaquées dans l'opération ultérieure de gravage ionique réactif profond (également connu sous l'abréviation « D.R.I.E. ») du silicium.

On exploite alors les zones exposées ou au contraire recouvertes de résine. Un premier processus de gravure permet de transférer dans l'oxyde de silicium préalablement crû, les motifs définis dans la résine aux étapes précédentes. Toujours dans une optique de répétabilité du processus de fabrication, l'oxyde de silicium est structuré par une gravure sèche par plasma, directionnelle et reproduisant la qualité des flancs de la résine servant de masque pour cette opération.

Une fois l'oxyde de silicium gravé dans les zones ouvertes de la résine, la surface de silicium de la première couche supérieure est alors exposée et prête pour une gravure DRIE. La résine peut être conservée ou non selon qu'on souhaite employer la résine comme masque lors de la gravure DRIE.

Le silicium exposé et non protégé par l'oxyde de silicium est gravé selon une direction perpendiculaire à la surface du wafer (gravure anisotrope DRIE Bosch^{®}). Les motifs formés d'abord dans la résine, puis dans l'oxyde de silicium, sont "projetés" dans l'épaisseur de la couche.

La première couche de silicium est alors structurée dans toute son épaisseur par les motifs définis représentant le corps, qui peut être détaché de la plaquette.

On obtient ainsi un corps 1, qui a par exemple une forme sensiblement parallélépipédique. Selon le procédé de l'invention, le corps 1, 5 comprend des évidements 3,6, qui s'étendent dans l'épaisseur du corps 1, 5 depuis la surface vers l'intérieur du corps 1, 5.

Dans une première variante de réalisation, les évidements 3, 6 sont creusés pendant la formation du corps 1, 5, par exemple pendant le processus de gravure ionique réactive profonde décrit précédemment.

Alternativement, les évidements 3, 6 sont creusés après la formation du corps 1, 5, par exemple grâce à un dispositif laser ou avec le processus de gravure ionique réactive profonde.

Optionnellement, la première étape comprend un processus d'oxydation-désoxydation pour agrandir et dimensionner les évidements 3, 6 avec précision, en retirant de la matière initiale en silicium. L'intérieur des évidements 3, 6 en silicium est oxydé pour faire croître une couche d'oxyde de silicium de type SiO₂ sur le silicium.

Un tel processus peut, par exemple, être obtenue par oxydation thermique. Une telle oxydation thermique peut, par exemple, être réalisée entre 800 et 1200 °C sous atmosphère oxydante à l'aide de vapeur d'eau ou de gaz de dioxygène permettant de former de l'oxyde de silicium dans les cavités. Lors de ce processus, on exploite le fait que l'oxyde de silicium croît de façon régulière, la vitesse d'oxydation et l'épaisseur qui en résulte sont parfaitement maitrisées par l'homme du métier, ce qui permet d'assurer l'uniformité de la couche d'oxyde.

Ensuite, on élimine la couche d'oxyde de silicium formée dans les évidements La sous-couche de silicium étant oxydée, elle est également supprimée. Une telle élimination est obtenue par gravure chimique. Une telle gravure chimique peut être réalisée, par exemple, au moyen d'une solution à base d'acide fluorhydrique en phase vapeur, qui permet de retirer l'oxyde de silicium.

Ainsi, on ajuste l'intérieur des évidements 3, 6 en creusant dans le silicium. En effet, lors de la croissance de l'oxyde de silicium sur du silicium, une sous-couche de silicium sur laquelle croît l'oxyde de silicium est elle-même oxydée. En effet, l'oxyde se diffuse dans le silicium au fur et à mesure.

Ainsi, l'oxyde de silicium croît aux dépens du silicium sur lequel il croît. Autrement dit, non seulement l'oxyde de silicium croît sur le silicium, mais il croît également dans le silicium.

De préférence, les évidements 3, 6 ont une forme de tranchée, de préférence fines.

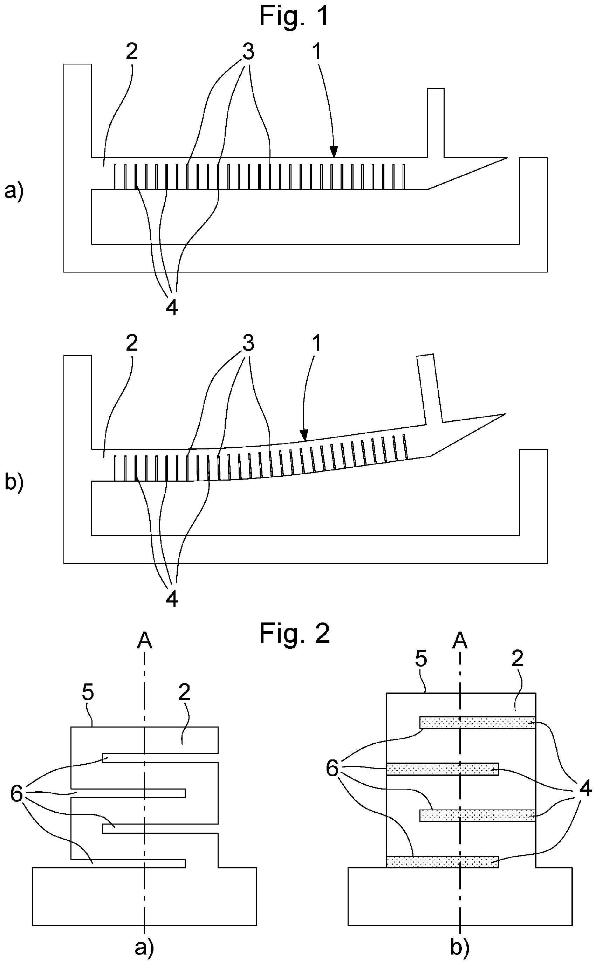

Dans une première variante des figures 1a) et 1b), les évidements 3 sont sensiblement parallèles, et sont agencés sur un côté du corps 3 seulement pour former un peigne.

Dans une deuxième variante des figures 2a) et 2b), les évidements 6 sont répartis uniformément dans le corps 5, notamment en forme de zigzag. Ainsi, on obtient un corps 5 dont l'épaisseur du matériau initial 2 est sensiblement la même dans tout le corps 5.

De préférence, les évidements 6 sont disposés symétriquement par rapport à un axe préférentiel A d'allongement du corps. Les évidements 6 sont agencés pour s'étendre dans le corps perpendiculairement à cet axe préférentiel A.

De préférence, ils sont de même longueur, et/ou ont un espacement constant entre eux.

Les évidements 3, 6 ont par exemple une largeur sensiblement constante en profondeur.

Alternativement, les évidements 6 ont une largeur variable en fonction de la profondeur de la tranchée, pour obtenir un élargissement progressif. Une telle variabilité permet de guider la déformation du corps.

Selon l'invention, le procédé comprend une deuxième étape de croissance d'oxyde de silicium 4 de type SiO₂ à l'intérieur desdits évidements 3, 6, de manière à remplir les évidements et à déformer le corps 1, 5 afin de modifier ses dimensions.

Dans cette étape, on fait croître l'oxyde de silicium à l'intérieur des évidements 3, 6 grâce au même processus d'oxydation exposé précédemment. De préférence, les évidements 3, 6 sont entièrement remplis d'oxyde de silicium 4.

Les propriétés mécaniques de l'oxyde de silicium 4 provoquent une modification des dimensions du corps 1, 5, car la croissance d'oxyde de silicium 4 déforme le matériau initial 2, à cause de la diffusion d'oxygène dans le réseau cristallin du silicium, qui rend le matériau plus volumineux. En outre, les évidements 3, 6 rendent le corps 1, 5 aisément déformable.

Dans le cas du corps 1 des figures 1a) et 1b), le corps devient courbe latéralement après la deuxième étape, car les évidements 3 sont agencés du même côté du corps 1.

Dans le cas du corps 5 des figures 2a) et 2b), ce-dernier est allongé axialement après la deuxième étape, car les évidements 6 sont agencés dans le corps 5 de manière homogène.

Ainsi, grâce à l'invention, on peut modifier les dimensions et/ou la géométrie de corps 1, 5.

Pour moduler la variation de géométrie du corps, on peut faire varier la largeur et/ou la profondeur des évidements 3, 6, ainsi que le nombre et la position des évidements disposés dans le corps 1, 5.

On peut aussi moduler la quantité d'oxyde de silicium 4 agencé à l'intérieur des évidements 3, 6 pour augmenter son impact sur les dimensions du corps 1, 5.

La deuxième étape peut comprendre plusieurs phases d'insertion d'oxyde de silicium 4 à l'intérieur des évidements 6, pour ajuster au mieux la déformation du corps 15 petit à petit. En particulier, avec des évidements 6 ayant un élargissement progressif, cet ajustement est encore plus précis.

Naturellement, l'invention n'est pas limitée aux modes de réalisation décrits en référence aux figures, et des variantes pourraient être envisagées sans sortir du cadre de l'invention.

## Revendications

1. Procédé de modification des dimensions d'un corps (1, 5), notamment pour l'horlogerie, le procédé comportant une première étape de formation du corps (1, 5) dans un matériau initial (2) comprenant du silicium, de préférence en totalité, le corps (1, 5) comportant des évidements (3, 6) s'étendant depuis la surface vers l'intérieur du corps (1, 5), **caractérisé en ce qu'**il comprend une deuxième étape de croissance d'oxyde de silicium de type SiO2 (4) à l'intérieur desdits évidements (3, 6), de manière à remplir les évidements et à déformer le corps (1, 5) afin de modifier ses dimensions.

2. Procédé selon la revendication 1, **caractérisé en ce que** l'étape de croissance d'oxyde de silicium (4) est produite par oxydation thermique, de préférence réalisée entre 800 et 1200 °C, à l'aide de vapeur d'eau ou de gaz de dioxygène.

3. Procédé selon la revendication 1 ou 2, **caractérisé en ce que** les évidements (3, 6) ont des formes de tranchées.

4. Procédé selon la revendication 3, **caractérisé en ce que** les évidements (3, 6) ont une largeur sensiblement constante en profondeur.

5. Procédé selon la revendication 3, **caractérisé en ce que** les évidements (3, 6) ont une largeur variable en fonction de la profondeur de la tranchée.

6. Procédé selon l'une quelconque des revendications précédentes, **caractérisé en ce que** les évidements (3, 6) sont agencés sur un côté du corps (1, 5), lors de la première étape, pour obtenir un corps (1, 5) courbe après la deuxième étape.

7. Procédé selon l'une quelconque des revendications 1 à 5, **caractérisé en ce que** le les évidements (3, 6) sont répartis uniformément dans le corps (1, 5), de manière à former un corps (1, 5) dont le matériau initial (2) a une épaisseur sensiblement constante dans le corps (1, 5), lors de la première étape, pour obtenir un corps (1, 5) allongé axialement après la deuxième étape.

8. Procédé selon l'une, quelconque, des revendications précédentes, **caractérisé en ce que**, lors de la première étape, les évidements (3, 6) sont creusés après la formation du corps (1, 5), par exemple grâce à un dispositif laser.

9. Procédé selon l'une, quelconque, des revendications 1 à 7, **caractérisé en ce que**, lors de la première étape, les évidements (3, 6) sont creusés pendant la formation du corps (1, 5).

10. Procédé selon l'une quelconque des revendications précédentes, **caractérisé en ce que** la première étape est effectuée via un processus de gravure ionique réactive profonde de type DRIE.

11. Procédé selon l'une quelconque des revendications précédentes, **caractérisé en ce que** la première étape comprend un processus d'oxydation-désoxydation pour agrandir les évidements (3, 6).
